(19) Europäisches Patentamt
European Patent Office
Office européen des brevets

(11) **EP 3 324 612 B1**

(12) **FASCICULE DE BREVET EUROPEEN**

(45) Date de publication et mention
de la délivrance du brevet:
**29.01.2020 Bulletin 2020/05**

(51) Int Cl.:
***H04N 5/363*** (2011.01)        ***H04N 5/374*** (2011.01)
***H01L 27/146*** (2006.01)

(21) Numéro de dépôt: **17200203.2**

(22) Date de dépôt: **06.11.2017**

(54) **CAPTEUR D'IMAGES CMOS À BRUIT RÉDUIT**

RAUSCHARMER CMOS-BILDSENSOR

REDUCED NOISE CMOS IMAGE SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.11.2016 FR 1661107**

(43) Date de publication de la demande:
**23.05.2018 Bulletin 2018/21**

(73) Titulaire: **Commissariat à l'Energie Atomique et
aux Energies
Alternatives
75015 Paris (FR)**

(72) Inventeur: **PEIZERAT, Arnaud
38000 GRENOBLE (FR)**

(74) Mandataire: **Cabinet Beaumont
4, Place Robert Schuman
B.P. 1529
38025 Grenoble Cedex 1 (FR)**

(56) Documents cités:
**EP-A1- 2 966 687        WO-A1-2005/096384
US-A1- 2006 202 242        US-A1- 2008 296 645**

**Description**

Domaine

La présente demande concerne le domaine des capteurs d'images CMOS. Elle vise notamment un capteur d'images CMOS à bruit réduit, adapté à fonctionner dans des conditions de faible luminosité.

Exposé de l'art antérieur

D'une manière classique, un capteur d'images CMOS comprend des pixels disposés en matrice selon des lignes et des colonnes. Chaque pixel comporte une photodiode utilisée en inverse, dont la capacité de jonction est déchargée par un photo-courant en fonction d'une intensité lumineuse reçue. A la fin d'une période dite d'acquisition d'image ou d'intégration, avant et après laquelle le pixel est réinitialisé par rechargement de sa photodiode, les charges photogénérées accumulées dans la photodiode sont transférées sur un noeud capacitif de lecture du pixel. La mesure du niveau d'éclairement reçu par le pixel s'effectue en mesurant la variation du potentiel du noeud de lecture du pixel, provoquée par le transfert, sur ce noeud, des charges photogénérées dans la photodiode du pixel.

En pratique, diverses sources de bruit sont susceptibles d'affecter la mesure, ce qui peut poser problème lorsque la quantité de charges photogénérées dans la photodiode est faible, notamment lorsque le capteur est utilisé dans des conditions de faible luminosité.

Il existe un besoin pour un capteur d'images CMOS palliant tout ou partie des inconvénients des capteurs existants. Plus particulièrement, il existe un besoin pour un capteur d'images CMOS à bruit réduit, adapté à fonctionner dans des conditions de faible luminosité.

Les demandes de brevet US 2008/296645 et US 2006/202242 décrivent des exemples de capteurs d'images comprenant des transistors MOS.

Résumé

Ainsi, un mode de réalisation prévoit un capteur d'images CMOS comportant au moins un pixel comportant :

une photodiode dont une première borne est reliée à un noeud d'application d'un premier potentiel de référence ;
un premier transistor MOS reliant une seconde borne de la photodiode à un noeud de lecture du pixel ;
un deuxième transistor MOS reliant le noeud de lecture à un noeud d'application d'un deuxième potentiel de référence ; et
un troisième transistor MOS monté en source suiveuse dont la grille est connectée au noeud de lecture et dont la source est destinée à être reliée à un circuit de lecture,
les premier, deuxième et troisième transistors ayant une même épaisseur d'isolant de grille,
dans lequel le troisième transistor présente une longueur de grille inférieure aux longueurs de grille des premier et deuxième transistors et/ou une largeur de grille inférieure aux largeurs de grille des premier et deuxième transistors,
la différence entre les premier et deuxième potentiels de référence est supérieure à la tension maximale pouvant être appliquée entre deux bornes du troisième transistor MOS, et la région de corps ou la région de drain du troisième transistor est reliée à un noeud d'application d'un troisième potentiel de référence compris entre les premier et deuxième potentiels.

Selon un mode de réalisation, la région de corps du troisième transistor est isolée de la région de corps du premier transistor et le troisième potentiel de référence appliqué sur la région de corps du troisième transistor est différent du potentiel appliqué sur la région de corps du premier transistor.

Selon un mode de réalisation, le troisième transistor est un transistor à canal P.

Selon un mode de réalisation, les premier et deuxième transistors sont des transistors à canal N, les régions de corps des premier et deuxième transistors étant reliées au noeud d'application du premier potentiel de référence, la région de corps du troisième transistor étant reliée au noeud d'application du deuxième potentiel de référence, et la région de drain du troisième transistor étant reliée au noeud d'application du troisième potentiel de référence.

Selon un mode de réalisation, le pixel comporte en outre un quatrième transistor MOS reliant la source du troisième transistor à une piste de sortie du pixel.

Selon un mode de réalisation, le quatrième transistor présente une longueur de grille supérieure à celle du troisième transistor et/ou une largeur de grille supérieure à celle du troisième transistor.

Selon un mode de réalisation, le quatrième transistor est un transistor du même type de conductivité que le troisième transistor.

Selon un mode de réalisation, la photodiode est une diode pincée comprenant une région d'accumulation

EP 3 324 612 B1

dopée de type N, formée dans un substrat dopé de type P, et une couche dopée de type P revêtant la région d'accumulation, ladite couche présentant un niveau de dopage supérieur à celui du substrat.

Selon un mode de réalisation, les premier, deuxième et troisième transistors sont des transistors à canal N, les régions de corps des premier et deuxième transistors étant reliées au noeud d'application du premier potentiel de référence, la région de corps du troisième transistor étant reliée au noeud d'application d'un quatrième potentiel de référence, et la région de drain du troisième transistor étant reliée à un noeud d'application d'un cinquième potentiel de référence.

Selon un mode de réalisation, le capteur est réalisé dans une filière technologique permettant de former sur une même puce des transistors MOS ayant une première épaisseur d'isolant de grille et des transistors MOS ayant une deuxième épaisseur d'isolant de grille supérieure à la première épaisseur, et les premier, deuxième et troisième transistors ont la deuxième épaisseur d'isolant de grille.

Selon un mode de réalisation, le capteur comporte en outre un circuit de contrôle périphérique comportant au moins un transistor MOS ayant une épaisseur d'isolant de grille inférieure à celle des premier, deuxième et troisième transistors.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma électrique d'un exemple d'un pixel d'un capteur d'images CMOS ;
la figure 2 est une vue en coupe simplifiée du pixel de la figure 1 ;
la figure 3 est un schéma électrique d'un exemple d'un mode de réalisation d'un pixel d'un capteur d'images CMOS ; et
la figure 4 est une vue en coupe schématique illustrant un exemple de réalisation du pixel de la figure 3.

Description détaillée

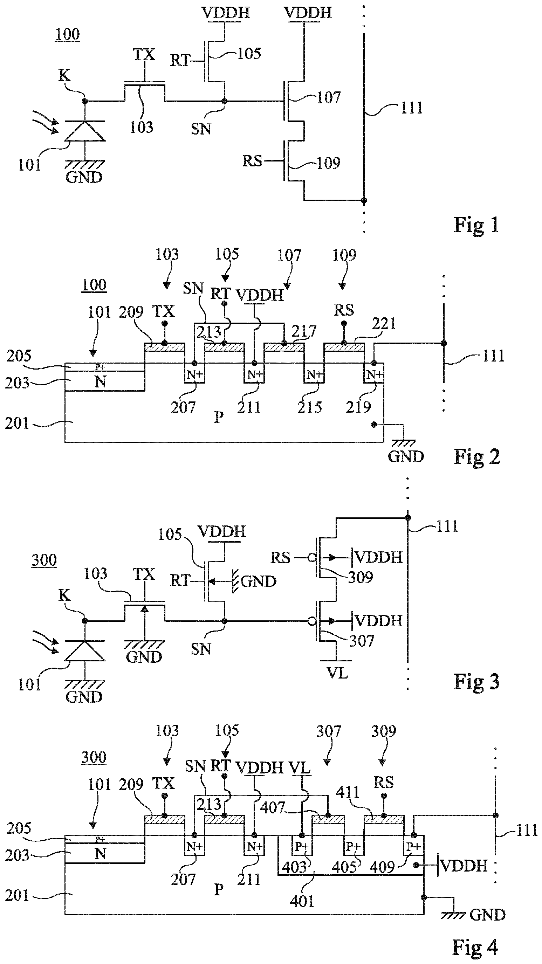

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les circuits périphériques de lecture et de commande des capteurs d'images décrits n'ont pas été détaillés, la réalisation de tels circuits étant à la portée de l'homme du métier à partir des indications fonctionnelles de la présente description. Dans la description qui suit, lorsque l'on fait référence à des qualificatifs de position absolue, tels que les termes "avant", "arrière", etc., ou relative, tels que les termes "dessus", "dessous", "supérieur", "inférieur", etc., il est fait référence à l'orientation des vues en coupe des figures 2 et 4, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près.

La figure 1 est un schéma électrique représentant un exemple d'un pixel 100 d'un capteur d'images CMOS. Le pixel 100 comprend une photodiode 101, un noeud d'accumulation K formé par la cathode de la photodiode 101, et un noeud de lecture SN. L'anode de la photodiode 101 est reliée à un noeud d'application d'un potentiel de référence bas GND, par exemple la masse. Le pixel 100 comprend en outre un transistor de transfert 103 dont les noeuds de conduction (source/drain) sont connectés respectivement au noeud K et au noeud SN, un transistor de réinitialisation 105 dont les noeuds de conduction sont connectés respectivement au noeud SN et à un noeud d'application d'un potentiel de référence haut VDDH, un transistor de lecture 107 monté en source suiveuse (connu sous la dénomination anglaise « source follower »), dont la grille est connectée au noeud SN et dont le drain est relié à un noeud d'application d'un potentiel de référence, et un transistor de sélection 109 dont les noeuds de conduction sont connectés respectivement à la source du transistor de lecture 107 et à une piste conductrice de sortie 111, généralement appelée colonne, qui peut être commune à plusieurs pixels du capteur.

Dans l'exemple représenté, les transistors 103, 105, 107 et 109 sont des transistors MOS à canal N, et le transistor 107, monté en source suiveuse (ou montage à drain commun), a son drain relié à un noeud d'application d'un potentiel de référence haut, le potentiel VDDH dans cet exemple.

En fonctionnement, les variations de potentiel du noeud SN sont reportées sur la source du transistor 107 sensiblement à l'identique, c'est-à-dire sans amplification ou avec un gain de l'ordre de 1. Le pixel 100 reçoit des signaux de commande TX, RT et RS appliqués respectivement sur les grilles des transistors 103, 105 et 109.

A titre d'exemple, le pixel 100 peut être commandé de la façon suivante :

- Pendant une phase d'intégration du pixel (précédée d'une étape de réinitialisation de la photodiode 101), le transistor de transfert 103 peut être maintenu non passant (signal TX à un état bas dans cet exemple) pour isoler le noeud

3

d'accumulation K du noeud de lecture SN. Les charges électriques générées dans la photodiode 101 sous l'effet de la lumière entraînent alors une diminution progressive du potentiel du noeud K.

- Avant la fin de la phase d'intégration, le transistor de réinitialisation 105 peut être rendu passant (signal RST à un état haut dans cet exemple) de façon à réinitialiser le potentiel du noeud de lecture SN au potentiel VDDH, puis le transistor 105 peut être ouvert de façon à isoler le noeud SN du noeud VDDH.

- Après l'étape de réinitialisation du noeud SN, le potentiel du noeud SN peut être lu et mémorisé lors d'une première étape de lecture, de façon à constituer une référence pour une étape ultérieure de mesure du niveau de décharge de la photodiode. Pour cela, le transistor de sélection 109 est rendu passant (signal RS à un état haut dans cet exemple), de sorte que le potentiel du noeud SN est reporté sur la piste de sortie 111, par l'intermédiaire des transistors 107 et 109. Le potentiel de la piste 111 peut alors être lu et mémorisé, via un circuit de lecture non représenté.

- Après la première étape de lecture, le transistor de transfert 103 peut être fermé (signal TX à l'état haut dans cet exemple) de façon à provoquer le transfert des charges photogénérées accumulées dans la photodiode sur le noeud de lecture SN. Le potentiel du noeud SN diminue alors d'une valeur représentative de la quantité de charges photogénérées accumulée dans la photodiode, et donc de l'intensité lumineuse reçue par la photodiode, pendant l'intégration.

- Le potentiel du noeud SN, reporté sur la piste de sortie 111 par les transistors 107 et 109, peut alors être à nouveau lu lors d'une deuxième étape de lecture, par un circuit de lecture non représenté.

- La valeur de sortie du pixel est par exemple égale à la différence entre le potentiel de référence $V_{OUT1}$ lu sur la piste 111 lors de la première étape de lecture, et le potentiel $V_{OUT2}$ lu sur la piste 111 lors de la deuxième étape de lecture.

Un avantage de ce procédé de lecture, généralement désigné dans la technique par l'acronyme CDS, de l'anglais "Correlated Double Sampling" - échantillonnage double corrélé, est qu'il permet de s'affranchir au moins en partie de certaines sources de bruit, telles que le bruit de réinitialisation introduit par le transistor 105.

D'autres procédés de lecture peuvent être utilisés pour réduire le bruit, par exemple un procédé de lecture du type généralement désigné dans la technique par l'acronyme CMS, de l'anglais "Correlated Multiple Sampling" - échantillonnage multiple corrélé, comprenant l'intégration de plusieurs échantillons successifs de la valeur de sortie du pixel, ce qui permet d'augmenter le rapport signal sur bruit.

La figure 2 est une vue en coupe simplifiée illustrant un exemple de réalisation du pixel 100 de la figure 1. Dans cet exemple, le pixel 100 est formé dans et sur une portion d'un substrat semiconducteur 201 (par exemple en silicium) dopé de type P.

La photodiode 101 est formée près de la surface supérieure ou face avant du substrat 201, et comprend une région dopée de type N 203, surmontée d'une région dopée de type P 205 de niveau de dopage supérieur à celui du substrat 201. La région 203 définit une zone d'accumulation de charges photogénérées. Dans cet exemple, la photodiode 101 est une photodiode dite pincée (en anglais "pinned diode"), ou photodiode enterrée. En l'absence de charges photogénérées, le potentiel de la région d'accumulation 203 est défini par les niveaux de dopage des régions 201, 203 et 205, et est par exemple égal à 1,5 V. L'utilisation d'une diode pincée permet de réduire de façon significative le bruit du pixel, et plus particulièrement le bruit lié aux courants d'obscurité et le bruit de réinitialisation.

Le transistor 103 comprend une région 207 dopée de type N, par exemple de niveau de dopage supérieur à celui de la région 203, séparée de la photodiode 101 par une région du substrat 201, et une grille isolée 209 revêtant la surface du substrat 201 entre la photodiode 101 et la région 207. La région 207 définit le drain du transistor 103, et la région 203 définit la source du transistor 103. La portion du substrat 201 située sous la grille 209, entre les régions 203 et 207, définit la région de corps, ou région de formation de canal, du transistor 103.

Le transistor 105 comprend une région 211 dopée de type N, par exemple de même niveau de dopage que la région 207, séparée de la région 207 par une portion du substrat 201, et une grille isolée 213 revêtant la surface du substrat 201 entre la région 207 et la région 211. La région 207 définit la source du transistor 105, et la région 211 définit le drain du transistor 105. La portion du substrat 201 située sous la grille 213, entre les régions 207 et 211, définit la région de corps, ou région de formation de canal, du transistor 105.

Le transistor 107 comprend une région 215 dopée de type N, par exemple de même niveau de dopage que la région 207, séparée de la région 211 par une portion du substrat 201, et une grille isolée 217 revêtant la surface du substrat 201 entre la région 211 et la région 215. La région 215 définit la source du transistor 107, et la région 211 définit le drain du transistor 107. La portion du substrat 201 située sous la grille 217, entre les régions 211 et 215, définit la région de corps, ou région de formation de canal, du transistor 107.

Le transistor 109 comprend une région 219 dopée de type N, par exemple de même niveau de dopage que la région 207, séparée de la région 215 par une portion du substrat 201, et une grille isolée 221 revêtant la surface du substrat 201 entre la région 215 et la région 219. La région 219 définit la source du transistor 109, et la région 215 définit le drain du transistor 109. La portion du substrat 201 située sous la grille 221, entre les régions 215 et 219, définit la région de corps, ou région de formation de canal, du transistor 109.

Dans cet exemple, la grille 209 du transistor 103 est connectée à un noeud d'application du signal TX, la grille 213 du transistor 105 est connectée à un noeud d'application du signal RT, la grille 217 du transistor 107 est connectée au noeud SN, la grille 221 du transistor 109 est connectée à un noeud d'application du signal RS, la région 207 est reliée au noeud SN, la région 211 est reliée à un noeud d'application du potentiel de référence haut VDDH, le substrat 201 (et par conséquent l'anode de la diode 101 ainsi que les régions de corps des transistors 103, 105, 107 et 109) est relié à un noeud d'application du potentiel de référence bas GND, et la région 219 est reliée à la piste de sortie 111.

Une source de bruit problématique dans les applications à faible niveau d'éclairement est le bruit de lecture produit par le transistor de lecture monté en source suiveuse, et plus particulièrement la composante en 1/f du bruit de lecture, aussi appelée bruit de scintillement. Cette source de bruit reste en effet significative même lorsqu'une lecture de type CDS ou CMS est mise en oeuvre, et peut devenir prépondérante dans des conditions de faible luminosité.

La demande de brevet EP2966687 précédemment déposée par le demandeur enseigne que la variance $\overline{Q^2}$ (en [Coulomb$^2$]) de la composante en 1/f du bruit de lecture rapportée à l'entrée, introduite par le transistor de lecture monté en source suiveuse, peut s'exprimer comme suit :

$$\overline{Q^2} = \alpha_{CMS} \frac{K}{C_{ox}{}^2 WL} (C_{SN} + c_{GS}WL + c_{GD}W)^2 \qquad (1),$$

K étant un paramètre proportionnel à kT dépendant de la technologie considérée (où k est la constante de Boltzman et T est la température absolue), $\alpha_{CMS}$ étant un facteur de réduction de bruit indépendant de la structure du pixel et dépendant uniquement du produit de la bande passante du circuit par la durée séparant les étapes successives de lecture des échantillons (dans le cas d'une lecture de type CMS), ainsi que du nombre d'échantillons accumulés pour générer la valeur de sortie du pixel, $C_{OX}$ étant la capacité surfacique grille-substrat formée par l'oxyde de grille du transistor de lecture monté en source suiveuse, W et L étant respectivement la largeur de grille (dimension orthogonale à la direction de circulation du courant source-drain) et la longueur de grille (dimension parallèle à la direction de circulation du courant source-drain) du transistor de lecture, $C_{SN}$ étant la capacité du noeud de lecture SN, dépendant notamment des capacités parasites du transistor de réinitialisation et du transistor de transfert, et $c_{GS}$ et $c_{GD}$ étant respectivement la capacité surfacique grille-source et la capacité linéique grille-drain du transistor de lecture.

Pour réduire la composante en 1/f du bruit de lecture, la demande de brevet EP2966687 susmentionnée propose un pixel dans lequel le transistor de lecture monté en source suiveuse présente une épaisseur d'oxyde de grille inférieure à celle des autres transistors du pixel.

En effet, dans une filière donnée de fabrication de puces de circuits intégrés en technologie CMOS, on dispose généralement de deux épaisseurs d'oxyde de grille différentes pour réaliser des transistors MOS. De façon classique, dans un capteur d'images comportant des pixels à quatre transistors MOS du type décrit en relation avec les figures 1 et 2, les quatre transistors du pixel (les transistors 103, 105, 107 et 109) sont des transistors à oxyde épais. Les transistors à oxyde épais peuvent en effet fonctionner à des tensions nominales supérieures aux tensions nominales de fonctionnement des transistors à oxyde mince, et permettent ainsi de réaliser des pixels présentant une gamme dynamique (ou plage de mesure) plus importante. L'utilisation de transistors à oxyde épais est tout particulièrement adaptée lorsque la photodiode est une diode pincée du type décrit en relation avec la figure 2. Ce type de photodiode présente en effet une tension à vide (en l'absence de charges photogénérées) qui peut être relativement élevée, par exemple voisine de la tension nominale de fonctionnement des transistors MOS à oxyde mince. Utiliser uniquement des transistors à oxyde mince ne permettrait alors pas d'obtenir une plage dynamique de fonctionnement du pixel suffisante.

Le pixel décrit dans la demande de brevet EP2966687 comporte une photodiode, un noeud de lecture, un transistor de transfert, un transistor de réinitialisation, et un transistor de lecture monté en source suiveuse, le transistor de transfert et le transistor de réinitialisation étant des transistors à oxyde épais, et le transistor de lecture étant un transistor à oxyde mince. L'utilisation d'un transistor de lecture à oxyde mince permet d'augmenter la capacité surfacique grille-substrat $C_{OX}$ formée par l'oxyde de grille du transistor de lecture par rapport à un pixel dans lequel tous les transistors sont des transistors à oxyde épais. Ceci permet de réduire de façon significative la composante en 1/f du bruit de lecture du pixel. De plus, un avantage supplémentaire est que les transistors MOS à oxyde mince peuvent être dimensionnés pour présenter une surface de grille (WL) inférieure à la surface de grille minimale qui peut être donnée aux transistors à oxyde épais. Ceci contribue là encore à réduire la composante en 1/f du bruit de lecture (comme cela ressort de l'équation (1) ci-dessus dans laquelle la surface WL est au carré au numérateur).

Dans la demande de brevet EP2966687 susmentionnée, pour ne pas perdre en dynamique par rapport à un pixel dans lequel tous les transistors sont à oxyde épais, la région de corps du transistor de lecture est isolée des régions de corps des transistors de transfert et de réinitialisation. Les régions de corps et de drain du transistor de lecture sont polarisées de façon que le transistor de lecture puisse recevoir sur sa grille la totalité de l'excursion de potentiel du noeud de lecture SN (allant du potentiel de réinitialisation au potentiel de saturation du pixel), sans que la tension grille-drain ou grille-corps du transistor de lecture ne dépasse la tension nominale de fonctionnement VDDL d'un transistor MOS à oxyde mince. Les régions de corps et de drain du transistor de lecture sont par exemple polarisées de façon que la tension corps-drain du transistor de lecture soit égale à la tension nominale de fonctionnement VDDL des transistors MOS à oxyde mince. Les transistors de transfert et de réinitialisation restent, eux, polarisés à une tension de préférence égale à la tension nominale VDDH de fonctionnement des transistors MOS à oxyde épais pour maximiser la plage de valeurs de mesure possible.

La solution décrite dans la demande de brevet EP2966687 susmentionnée présente toutefois des limitations, notamment dans les filières de fabrication CMOS avancées, typiquement dans les filières dans lesquelles la plus petite longueur de grille de transistor MOS réalisable est inférieure ou égale à 130 nm.

En effet, les inventeurs ont constaté que, dans les filières avancées, le pixel décrit dans la demande de brevet EP2966687 est sujet non seulement au bruit en 1/f susmentionné, mais aussi à une autre source de bruit qui pouvait être négligée dans les filières plus anciennes, lié à l'écoulement d'un courant de fuite à travers l'oxyde de grille du transistor de lecture monté en source suiveuse. Ce bruit de fuite, aussi appelé "shot noise" en langue anglaise, ou bruit de grenaille, est lié à la diminution significative de l'épaisseur de l'oxyde de grille des transistors à oxyde mince dans les technologies avancées, conduisant à l'écoulement d'un courant par effet tunnel du noeud de lecture SN vers le corps et/ou le drain du transistor de lecture, à travers l'oxyde de grille du transistor de lecture. La variance $\overline{Q^2}$ (en [Coulomb$^2$]) du bruit de fuite rapporté à l'entrée, introduit par le transistor de lecture monté en source suiveuse, peut s'exprimer comme suit :

$$\overline{Q^2} = 2\alpha_{shot}qI_LT_S \qquad (2),$$

$I_L$ étant la valeur moyenne du courant de fuite total à travers l'oxyde de grille du transistor de lecture, q étant la charge en électrons sur le noeud de lecture, $T_S$ étant la durée entre les étapes de lecture successives du procédé de lecture à échantillonnage multiple corrélé, et $\alpha_{shot}$ étant un paramètre constant fonction du nombre M d'étapes de lecture successives du procédé de lecture à échantillonnage multiple corrélé (sensiblement égal à 0,5 pour M = 2, c'est-à-dire dans le cas d'une lecture à échantillonnage double corrélé).

Ce bruit de fuite vient s'additionner au bruit en 1/f susmentionné, exprimé par l'équation (1).

Selon la filière technologique considérée, le bruit de fuite peut devenir significatif, voire prépondérant, annulant les avantages décrits ci-dessus liés à l'utilisation d'un transistor de lecture à oxyde mince.

Selon un aspect d'un mode de réalisation, on prévoit un pixel comportant une photodiode, un noeud de lecture, un transistor de transfert, un transistor de réinitialisation, et un transistor de lecture monté en source suiveuse, dans lequel le transistor de transfert, le transistor de réinitialisation et le transistor de lecture présentent sensiblement la même épaisseur d'oxyde de grille, et dans lequel le transistor de lecture présente une longueur de grille L inférieure à la plus petite des longueurs de grille des transistors de transfert et de réinitialisation, et/ou une largeur de grille W inférieure à la plus petite des largeurs de grille des transistors de transfert et de réinitialisation.

La prévision d'un transistor de lecture de dimensions L et/ou W réduites par rapport aux transistors de transfert et de réinitialisation permet de réduire la composante en 1/f du bruit de lecture du pixel. De préférence, les transistors sont des transistors à oxyde épais, ce qui permet en outre de diminuer significativement, et même de rendre négligeable, la composante du bruit de lecture liée à la fuite dans l'oxyde de grille du transistor de lecture.

Dans une filière donnée de fabrication de puces de circuits intégrés en technologie CMOS, pour une épaisseur d'oxyde de grille donnée, et pour une tension nominale de fonctionnement donnée, il existe classiquement une longueur de grille minimale $L_{min}$ et une largeur de grille minimale $W_{min}$ en dessous desquelles il convient de ne pas descendre pour ne pas risquer un claquage du transistor.

Selon un aspect, on prévoit ici de donner au transistor de lecture du pixel une longueur de grille L inférieure à la longueur de grille minimale $L_{min}$ que peuvent accepter les transistors de transfert et de réinitialisation à leur tension de fonctionnement nominale VDDH, et/ou une largeur de grille W inférieure à la largeur de grille minimale $W_{min}$ que peuvent accepter les transistors de transfert et de réinitialisation à leur tension de fonctionnement nominale VDDH. La tension maximale VDDL' que peut supporter le transistor de lecture, ou tension nominale de fonctionnement du transistor de lecture, est alors inférieure à la tension nominale de fonctionnement VDDH des transistors de transfert et de réinitialisation.

Pour ne pas perdre en dynamique par rapport à un pixel dans lequel tous les transistors sont à oxyde épais et peuvent fonctionner à la tension VDDH, la région de corps du transistor de lecture est isolée des régions de corps des transistors de transfert et de réinitialisation. Les régions de corps et de drain du transistor de lecture sont polarisées de façon que le transistor de lecture puisse recevoir sur sa grille la totalité de l'excursion de potentiel du noeud de lecture SN (allant du potentiel de réinitialisation au potentiel de saturation du pixel), sans que la tension grille-drain ou grille-corps du transistor de lecture ne dépasse la tension VDDL'. Les régions de corps et de drain du transistor de lecture sont par exemple polarisées de façon que la tension corps-drain du transistor de lecture soit égale à la tension VDDL'. Les transistors de transfert et de réinitialisation restent, eux, polarisés à une tension de préférence égale à leur tension nominale de fonctionnement VDDH, pour maximiser la plage de valeurs de mesure possible.

La figure 3 est un schéma électrique d'un exemple de réalisation d'un pixel 300 d'un capteur d'images CMOS. Le pixel 300 comprend, comme le pixel 100 de l'exemple de la figure 1, une photodiode 101, un noeud d'accumulation K formé par la cathode de la photodiode 101, et un noeud de lecture SN. L'anode de la photodiode 101 est reliée à un noeud d'application d'un potentiel de référence bas GND, par exemple la masse. Le pixel 300 comprend en outre, comme dans l'exemple de la figure 1, un transistor de transfert 103 reliant le noeud K au noeud SN, et un transistor de réinitialisation 105 reliant le noeud SN à un noeud d'application d'un potentiel de référence haut VDDH. Le pixel 300 comprend en outre un transistor de lecture 307 monté en source suiveuse, dont la grille est connectée au noeud SN et dont le drain est relié à un noeud d'application d'un potentiel de référence intermédiaire VL, et un transistor de sélection 309 dont les noeuds de conduction sont connectés respectivement à la source du transistor de lecture 307 et à une piste conductrice de sortie 111, qui peut être commune à plusieurs pixels du capteur.

Dans l'exemple représenté, les transistors 103 et 105 sont des transistors MOS à canal N, et les transistors 307 et 309 sont des transistors MOS à canal P. Dans cet exemple, les transistors 103, 105, 307 et 309 sont des transistors à oxyde épais. Les transistors 103 et 105 présentent des dimensions W et L telles qu'ils peuvent supporter sans dégradation la tension de polarisation VDDH du pixel. Autrement dit, la tension nominale de fonctionnement des transistors 103 et 105 est supérieure ou égale à la tension de polarisation VDDH du pixel. Le transistor 307 présente en revanche une longueur de grille réduite et/ou une largeur de grille réduite, d'où il résulte que la tension maximale VDDL' que peut supporter le transistor 307 est inférieure à la tension de polarisation VDDH du pixel.

Les transistors 103 et 105 ont leurs régions de corps reliées à un noeud d'application du potentiel de référence bas GND, et les transistors 307 et 309 ont leurs régions de corps reliées à un noeud d'application du potentiel de référence haut VDDH. Le transistor de lecture 307 a son drain relié à un noeud d'application d'un potentiel de référence intermédiaire VL, compris entre le potentiel de référence bas GND et le potentiel de référence haut VDDH. A titre de variante, la région de corps du transistor de lecture 307 peut être reliée à la source de ce même transistor.

En fonctionnement, les variations de potentiel du noeud SN sont reportées sur la source du transistor 307 sensiblement à l'identique. Le pixel 300 reçoit des signaux de commande TX, RT et RS appliqués respectivement sur les grilles des transistors 103, 105 et 309.

A titre d'exemple, le pixel 300 peut être commandé sensiblement de la même manière que le pixel 100 de la figure 1, en adaptant le niveau des signaux logiques en fonction du type de conductivité des transistors.

La tension VDDH (prise par rapport à la masse GND) est par exemple sensiblement égale à la tension nominale de fonctionnement des transistors 103 et 105. Le potentiel intermédiaire VL appliqué sur le drain du transistor 307 peut être choisi de façon que, dans des conditions normales d'utilisation du pixel, le transistor 307 ne voie jamais une tension supérieure à la tension maximale VDDL' (prise par rapport à la masse) qu'il peut supporter en tenant compte de la réduction de ses dimensions. A titre d'exemple, la différence de tension VDDH-VL correspond à la tension nominale de fonctionnement VDDL' du transistor 307.

A titre d'exemple illustratif (non limitatif), on considère une filière technologique dans laquelle les transistors MOS à oxyde épais sont prévus pour fonctionner à des tensions pouvant aller jusqu'à 3,3 V pour autant que leur longueur de grille ne soit pas inférieure à une valeur $L_{min}$ = 0,5 $\mu$m et que leur largeur de grille ne soit pas inférieure à une valeur $W_{min}$ inférieure à 0,4 $\mu$m. On prévoit alors de donner au transistor 307 une longueur de grille de l'ordre de 0,3 $\mu$m et une largeur de grille de l'ordre de 0,3 pm, d'où il résulte que la tension maximale que peut supporter le transistor 307 est de l'ordre de 2,5 V. Le potentiel de référence bas GND est par exemple égal à 0 V, et le potentiel de référence haut VDDH à 3,3 V. Le potentiel de référence intermédiaire VL appliqué sur le drain du transistor de lecture 307 est alors choisi supérieur ou égal à 0,8 V de façon que le transistor 307 ne voie jamais une tension supérieure à 2,5 V entre deux quelconques de ses quatre bornes (grille, source, drain, corps).

Si la tension à vide Vpin de la photodiode est du même ordre de grandeur que la tension nominale d'alimentation VDDL' du transistor 307, alors la plage de variation du potentiel (ou tension prise par rapport à la masse) $V_{SN}$ du noeud de lecture a une amplitude sensiblement égale à VDDL'. Plus précisément, le potentiel $V_{SN}$ varie entre une valeur Vpin et la tension maximale de réinitialisation du noeud SN, qui vaut VDDH-$V_{tn}$, où $V_{tn}$ est la tension de seuil du transistor NMOS de réinitialisation. Si l'amplitude de variation au noeud SN, égale à VDDH-Vtn-Vpin, est inférieure à la tension VDDL' alors il est possible de trouver un potentiel de référence VL du transistor de lecture qui permette de respecter la tension maximale acceptée entre deux bornes du transistor de lecture.

Le transistor de sélection 309 est de préférence un transistor MOS de dimensions supérieures ou égales aux dimensions minimales $W_{min}$ et $L_{min}$ à respecter pour tenir la tension VDDH. En effet, l'utilisation d'un transistor de sélection de dimensions réduites nécessiterait de commander la grille de ce transistor avec une tension de commande présentant une excursion contrôlée pour ne pas endommager le transistor. Dans le cas de l'exemple décrit ci-dessus, en relation avec la figure 3, la tension de commande de la grille du transistor de sélection 309, si ce dernier présentait des dimensions réduites telles que sa tension nominale de fonctionnement soit égale à VDDL', pourrait par exemple osciller entre un niveau bas égal au potentiel de référence VL et le potentiel de référence haut VDDH. La mise en oeuvre d'une telle commande rend toutefois plus complexe la réalisation des circuits périphériques de commande du capteur.

De plus, il est préférable que le transistor de sélection 309 soit du même type de conductivité que le transistor de lecture 307, afin que le niveau de potentiel présent sur la source du transistor de lecture soit correctement transmis sur la piste conductrice de sortie 111 du pixel.

La figure 4 est une vue en coupe simplifiée illustrant un exemple de réalisation du pixel 300 de la figure 3. Dans cet exemple, le pixel 300 est formé dans et sur une portion d'un substrat semiconducteur 201 (par exemple en silicium) dopé de type P. La photodiode 101, le transistor 103 et le transistor 105 sont sensiblement identiques à ce qui a été décrit en relation avec la figure 2, et les transistors 307 et 309 sont réalisés dans un même caisson 401 dopé de type N, formé dans une partie supérieure du substrat 201.

Le transistor 307 comprend deux régions 403 et 405 dopées de type P, formées dans une partie supérieure du caisson 401 et séparées par une portion du caisson 401. Le transistor 307 comprend en outre une grille isolée 407 revêtant la surface du caisson 401 entre la région 403 et la région 405. La région 403 définit la région de drain du transistor 307, et la région 405 définit la région de source du transistor 307. La portion du caisson 401 située sous la grille 407, entre les régions 403 et 405, définit la région de corps, ou région de formation de canal, du transistor 307.

Le transistor 309 comprend une région 409 dopée de type P, par exemple de même niveau de dopage que les régions 403 et 405, séparée de la région 405 par une portion du caisson 401, et une grille isolée 411 revêtant la surface du caisson 401 entre la région 405 et la région 409. La région 405 définit la région de drain du transistor 309, et la région 409 définit la région de source du transistor 309. La portion du caisson 401 située sous la grille 411, entre les régions 405 et 409, définit la région de corps, ou région de formation de canal, du transistor 309.

Dans cet exemple, la grille 209 du transistor 103 est connectée à un noeud d'application du signal TX, la grille 213 du transistor 105 est connectée à un noeud d'application du signal RT, la grille 407 du transistor 307 est connectée au noeud SN, la grille 411 du transistor 309 est connectée à un noeud d'application du signal RS, la région 207 est reliée au noeud SN, la région 211 est reliée à un noeud d'application du potentiel de référence haut VDDH, le substrat 201 (et par conséquent l'anode de la diode 103 ainsi que les régions de corps des transistors 103 et 105) est relié à un noeud d'application du potentiel de référence bas GND, le caisson 401 (et par conséquent les régions de corps des transistors 307 et 309) est relié à un noeud d'application du potentiel de référence haut VDDH, la région 403 est reliée à un noeud d'application du potentiel de référence intermédiaire VL, et la région 409 est reliée à la piste de sortie 111.

Dans l'exemple représenté, les transistors 103, 105 et 309 présentent sensiblement la même longueur de grille, supérieure à la longueur de grille du transistor 307.

Avantageusement, dans le cas d'un capteur d'images à plusieurs pixels, des pixels voisins peuvent partager un même caisson 401 de formation des transistors 307 et 309, ce qui permet de réduire l'encombrement du capteur.

Des modes de réalisation particuliers ont été décrits. Diverses variantes et modifications apparaîtront à l'homme de l'art.

En particulier, l'homme du métier saura adapter les modes de réalisation décrits au cas où le transistor de lecture monté en source suiveuse est un transistor MOS de type N. Dans ce cas, la région de corps du transistor de lecture peut être isolée des régions de corps des transistors de transfert et de réinitialisation à l'aide d'une structure à triple caisson, afin de pouvoir isoler la région de corps du transistor de lecture du substrat 201, de façon à pouvoir les polariser à des tensions différentes. La région de corps du transistor de lecture peut alors être reliée à un noeud d'application d'un potentiel de référence intermédiaire VrefLow qui est de préférence inférieur ou égal à la tension minimale pouvant être présente sur la source du transistor de lecture, soit Vpin-Vt1 (où Vt1 est la tension de seuil du transistor de lecture de dimensions réduites), par exemple 1,5V-0,5V = 1V. La région de drain du transistor de lecture est alors reliée à un noeud d'application d'un potentiel de référence VrefHigh, qui, de préférence, ne dépasse pas VrefLow + VDDL'. Les potentiels de référence VrefLow et VrefHigh sont ainsi de préférence choisis de façon que le transistor de lecture ne voie jamais à ses bornes une tension supérieure à la tension VDDL'.

Un tel mode de réalisation avec un transistor de lecture de type NMOS nécessite l'utilisation d'une structure à triple caisson qui est volumineuse et diminue la densité de pixels. En outre, deux références de tension VrefLow et Vrefhigh, différentes des tensions d'alimentation et de la masse, peuvent s'avérer nécessaires en pratique pour respecter les contraintes en tension du transistor de dimensions réduites. Pour ce dernier point, il est éventuellement envisageable de polariser le drain du transistor de réinitialisation 105 à la même tension Vrefhigh que celle appliquée sur le drain du transistor de sélection NMOS car le niveau maximal pouvant passer à travers le transistor NMOS est égal à VDDH-Vtn2 (Vtn2 étant la tension de seuil du transistor NMOS de réinitialisation), soit par exemple 3,3V-0,5V = 2,8V.

De plus, les inventeurs ont constaté en pratique que l'utilisation d'un transistor NMOS comme transistor de lecture ne permet pas d'avoir d'aussi bons résultats pour le bruit en 1/f qu'avec un transistor PMOS.

Ainsi, dans le cas d'une photodiode de type diode pincée associée à un transistor de transfert NMOS, le mode de réalisation préféré est celui décrit en relation avec la figure 3, avec des transistors de transfert et de réinitialisation de type NMOS, un transistor de lecture de type PMOS de dimensions réduites, et un transistor de sélection de type PMOS.

**EP 3 324 612 B1**

Bien que l'utilisation d'une photodiode pincée de type opposé à celui représenté en figure 3 soit relativement rare, on pourrait avoir une photodiode N+/P/N, sur un substrat de type N, associée à un transistor de transfert de type PMOS. Dans ce cas, on pourrait envisager d'avoir uniquement des transistors de type PMOS, le transistor de lecture ayant des dimensions réduites par rapport aux transistors de transfert et de réinitialisation, et de préférence, par rapport au transistor de sélection. En outre, dans le cas d'une telle photodiode N+/P/N, la cathode serait reliée au potentiel de référence haut VDDH et l'anode serait reliée au transistor de transfert.

En outre, bien que les exemples susmentionnés présentent des transistors de transfert et de réinitialisation du même type, ils pourraient être différents. Néanmoins, pour des raisons de densité et également de limitation des surfaces de caissons susceptibles de créer des diodes parasites, on préférera l'utilisation d'un même type de transistors.

Par ailleurs, les modes de réalisation décrits ne se limitent pas aux exemples numériques de potentiels de polarisation mentionnés ci-dessus.

De plus, les modes de réalisation décrits ne se limitent pas au cas particulier décrit ci-dessus, dans lequel la photodiode est une diode pincée.

**Revendications**

1. Capteur d'images CMOS comportant au moins un pixel (300) comportant :

    une photodiode (101) dont une première borne est reliée à un noeud d'application d'un premier potentiel de référence (GND) ;
    un premier transistor MOS (103) reliant une seconde borne de la photodiode (101) à un noeud de lecture du pixel (SN) ;
    un deuxième transistor MOS (105) reliant le noeud de lecture (SN) à un noeud d'application d'un deuxième potentiel de référence (VDDH) ; et
    un troisième transistor MOS (307) monté en source suiveuse dont la grille (407) est connectée au noeud de lecture (SN) et dont la source est destinée à être reliée à un circuit de lecture,
    les premier (103), deuxième (105) et troisième (307) transistors ayant une même épaisseur d'isolant de grille, **caractérisé en ce que** le troisième transistor (307) présente une longueur de grille inférieure aux longueurs de grille des premier (103) et deuxième (105) transistors et/ou une largeur de grille inférieure aux largeurs de grille des premier (103) et deuxième (105) transistors, **en ce que** la différence entre les premier (GND) et deuxième (VDDH) potentiels de référence est supérieure à la tension maximale pouvant être appliquée entre deux bornes du troisième transistor MOS (307), et **en ce que** la région de corps ou la région de drain du troisième transistor (307) est reliée à un noeud d'application d'un troisième potentiel de référence (VL) compris entre les premier (GND) et deuxième (VDDH) potentiels.

2. Capteur selon la revendication 1, dans lequel la région de corps du troisième transistor (307) est isolée de la région de corps du premier transistor (103) et le troisième potentiel de référence (VL) appliqué sur la région de corps du troisième transistor (307) est différent du potentiel appliqué sur la région de corps du premier transistor (103).

3. Capteur selon la revendication 1 ou 2, dans lequel le troisième transistor (307) est un transistor à canal P.

4. Capteur selon la revendication 3, dans lequel les premier (103) et deuxième (105) transistors sont des transistors à canal N, les régions de corps des premier (103) et deuxième (105) transistors étant reliées au noeud d'application du premier potentiel de référence (GND), la région de corps du troisième transistor (307) étant reliée au noeud d'application du deuxième potentiel de référence (VDDH), et la région de drain du troisième transistor (307) étant reliée au noeud d'application du troisième potentiel de référence (VL).

5. Capteur selon l'une quelconque des revendications 1 à 4, dans lequel ledit au moins un pixel (300) comporte en outre un quatrième transistor MOS (309) reliant la source du troisième transistor (307) à une piste de sortie (111) du pixel.

6. Capteur selon la revendication 5, dans lequel le quatrième transistor (309) présente une longueur de grille supérieure à celle du troisième transistor (307) et/ou une largeur de grille supérieure à celle du troisième transistor (307).

7. Capteur selon la revendication 5 ou 6, dans lequel le quatrième transistor (309) est un transistor du même type de conductivité que le troisième transistor (307).

8. Capteur selon l'une quelconque des revendications 1 à 7, dans lequel la photodiode (101) est une diode pincée comprenant une région d'accumulation (203) dopée de type N, formée dans un substrat (201) dopé de type P, et une couche (205) dopée de type P revêtant la région d'accumulation (203), ladite couche (205) présentant un niveau de dopage supérieur à celui du substrat (201).

9. Capteur selon la revendication 2, dans lequel les premier (103), deuxième (105) et troisième transistors sont des transistors à canal N, les régions de corps des premier (103) et deuxième (105) transistors étant reliées au noeud d'application du premier potentiel de référence (GND), la région de corps du troisième transistor (307) étant reliée au noeud d'application d'un quatrième potentiel de référence (Vreflow), et la région de drain du troisième transistor (307) étant reliée à un noeud d'application d'un cinquième potentiel de référence (Vrefhigh).

10. Capteur selon l'une quelconque des revendications 1 à 9, réalisé dans une filière technologique permettant de former sur une même puce des transistors MOS ayant une première épaisseur d'isolant de grille et des transistors MOS ayant une deuxième épaisseur d'isolant de grille supérieure à la première épaisseur, dans lequel les premier (103), deuxième (105) et troisième (307) transistors ont la deuxième épaisseur d'isolant de grille.

11. Capteur selon l'une quelconque des revendications 1 à 10, comportant en outre un circuit de contrôle périphérique comportant au moins un transistor MOS ayant une épaisseur d'isolant de grille inférieure à celle des premier (103), deuxième (105) et troisième (307) transistors.

**Patentansprüche**

1. CMOS-Bildsensor mit wenigstens einem Pixel (300), der folgendes aufweist:

   eine Photodiode (101) mit einem ersten Anschluss, der mit einem Knoten zum Anlegen eines ersten Bezugs- bzw. Referenzpotentials (GND) verbunden ist; einen ersten MOS-Transistor (103), der einen zweiten Anschluss der Photodiode (101) mit einem Lese- bzw. Abtastknoten (SN) des Pixels verbindet;
   einen zweiten MOS-Transistor (105), der den Leseknoten (SN) mit einem Knoten zum Anlegen eines zweiten Bezugspotentials (VDDH) verbindet; und
   einen dritten MOS-Transistor (307), der als Source-Folger angeordnet ist mit seinem Gate (407) mit dem Leseknoten (SN) verbunden und dessen Source dazu bestimmt ist, mit einer Ausleseschaltung verbunden zu werden,
   die ersten (103), zweiten (105) und dritten (307) Transistoren mit einer gleichen Gate-Isolatordicke,
   wobei der dritte Transistor (307) eine Gate-Länge aufweist, die kleiner ist als die Gate-Längen der ersten (103) und zweiten (105) Transistoren und/oder eine Gate-Breite, die kleiner ist als die Gate-Breiten der ersten (103) und zweiten (105) Transistoren, wobei die Differenz zwischen dem ersten (GND) und zweiten (VDDH) Bezugspotential größer ist als die maximale Spannung, die zwischen zwei Anschlüssen des dritten MOS-Transistors (307) angelegt werden kann, und wobei der Körperbereich oder der Drainbereich des dritten Transistors (307) mit einem Knoten zum Anlegen eines dritten Bezugspotentials (VL) zwischen den ersten (GND) und zweiten (VDDH) Potentialen verbunden ist.

2. Sensor nach Anspruch 1, wobei der Körperbereich des dritten Transistors (307) von dem Körperbereich des ersten Transistors (103) isoliert ist und sich das dritte Bezugspotential (VL), das an den Körperbereich des dritten Transistors (307) angelegt wird, von dem an den Körperbereich des ersten Transistors (103) angelegten Potentials unterscheidet.

3. Sensor nach Anspruch 1 oder 2, wobei der dritte Transistor (307) ein P-Kanal-Transistor ist.

4. Sensor nach Anspruch 3, wobei erste (103) und zweite (105) Transistoren N-Kanal-Transistoren sind, wobei die Körperbereiche der ersten (103) und zweiten (105) Transistoren mit dem Knoten zum Anlegens des ersten Bezugspotentials (GND) verbunden sind, der Körperbereich des dritten Transistors (307) mit dem Knoten zum Anlegen des zweiten Bezugspotentials (VDDH) verbunden ist und der Drainbereich des dritten Transistors (307) mit dem Knoten zum Anlegen des dritten Bezugspotentials (VL) verbunden ist.

5. Sensor nach einem der Ansprüche 1 bis 4, wobei das wenigstens eine Pixel (300) ferner einen vierten MOS-Transistor (309) aufweist, der die Source des dritten Transistors (307) mit einer Ausgangsspur (111) des Pixels verbindet.

6. Sensor nach Anspruch 5, wobei der vierte Transistor (309) eine Gate-Länge aufweist, die größer ist als die des dritten Transistors (307) und/oder eine Gate-Breite, die größer ist als die des dritten Transistors (307).

7. Sensor nach Anspruch 5 oder 6, wobei der vierte Transistor (309) ein Transistor vom gleichen Leitfähigkeitstyp wie der dritte Transistor (307) ist.

8. Sensor nach einem der Ansprüche 1 bis 7, wobei die Photodiode (101) eine gebundene ("pinned") Diode ist, die einen N-dotierten Speicherbereich (203), der in einem P-dotierten Substrat (201) ausgebildet ist, und eine P-dotierte Schicht (205) aufweist, die den Speicherbereich (203) abdeckt, wobei die Schicht (205) einen höheren Dotierungsgrad als das Substrat (201) aufweist.

9. Sensor nach Anspruch 2, wobei die ersten (103), zweiten (105) und dritten Transistoren N-Kanal-Transistoren sind, wobei die Körperbereiche der ersten (103) und zweiten (105) Transistoren mit dem Knoten zum Anlegen des ersten Bezugspotentials (GND) verbunden sind, wobei der Körperbereich des dritten Transistors (307) mit dem Knoten zum Anlegen eines vierten Bezugspotentials (VrefLow) verbunden ist und der Drainbereich des dritten Transistors (307) mit einem Knoten zum Anlegen eines fünften Bezugspotentials (VrefHigh) verbunden ist.

10. Sensor nach einem der Ansprüche 1 bis 9, der mit einem technologischen Verfahren ausgebildet ist, das es ermöglicht, auf einem gleichen Chip MOS-Transistoren mit einer ersten Gate-Isolatordicke und MOS-Transistoren mit einer zweiten Gate-Isolatordicke, die größer als die erste Dicke ist, auszubilden, wobei die ersten (103), zweiten (105) und dritten (307) Transistoren die zweite Gate-Isolatordicke aufweisen.

11. Sensor nach einem der Ansprüche 1 bis 10, der ferner eine periphere Steuerschaltung mit wenigstens einem MOS-Transistor mit einer Gate-Isolatordicke aufweist, die kleiner ist als die des ersten (103), zweiten (105) und dritten (307) Transistors.

**Claims**

1. A CMOS image sensor comprising at least one pixel (300) comprising:

    a photodiode (101) having a first terminal connected to a node of application of a first reference potential (GND);
    a first MOS transistor (103) connecting a second terminal of the photodiode (101) to a sense node (SN) of the pixel;
    a second MOS transistor (105) connecting the sense node (SN) to a node of application of a second reference potential (VDDH); and
    a third MOS transistor (307) assembled as a source follower having its gate (407) connected to the sense node (SN) and having its source intended to be connected to a readout circuit,
    the first (103), second (105), and third (307) transistors having a same gate insulator thickness,
    wherein the third transistor (307) has a gate length smaller than the gate lengths of the first (103) and second (105) transistors and/or a gate width smaller than the gate widths of the first (103) and second (105) transistors,
    wherein the difference between the first (GND) and second (VDDH) reference potentials is greater than the maximum voltage which may be applied between two terminals of the third MOS transistor (307), and wherein the body region or the drain region of the third transistor (307) is connected to a node of application of a third reference potential (VL) between the first (GND) and second (VDDH) potentials.

2. The sensor of claim 1, wherein the body region of the third transistor (307) is insulated from the body region of the first transistor (103) and the third reference potential (VL) applied to the body region of the third transistor (307) is different from the potential applied to the body region of the first transistor (103).

3. The sensor of claim 1 or 2, wherein the third transistor (307) is a P-channel transistor.

4. The sensor of claim 3, wherein first (103) and second (105) transistors are N-channel transistors, the body regions of the first (103) and second (105) transistors being connected to the node of application of the first reference potential (GND), the body region of the third transistor (307) being connected to the node of application of the second reference potential (VDDH), and the drain region of the third transistor (307) being connected to the node of application of the third reference potential (VL).

5. The sensor of any of claims 1 to 4, wherein said at least one pixel (300) further comprises a fourth MOS transistor (309) connecting the source of the third transistor (307) to an output track (111) of the pixel.

6. The sensor of claim 5, wherein the fourth transistor (309) has a gate length greater than that of the third transistor (307) and/or a gate width greater than that of the third transistor (307).

7. The sensor of claim 5 or 6, wherein the fourth transistor (309) is a transistor of same conductivity type as the third transistor (307).

8. The sensor of any of claims 1 to 7, wherein the photodiode (101) is a pinned diode comprising an N-type doped storage region (203), formed in a P-type doped substrate (201), and a P-type doped layer (205) coating the storage region (203), said layer (205) having a higher doping level than the substrate (201).

9. The sensor of claim 2, wherein the first (103), second (105), and third transistors are N-channel transistors, the body regions of the first (103) and second (105) transistors being connected to the node of application of the first reference potential (GND), the body region of the third transistor (307) being connected to the node of application of a fourth reference potential (VrefLow), and the drain region of the third transistor (307) being connected to a node of application of a fifth reference potential (VrefHigh).

10. The sensor of any of claims 1 to 9, formed with a technological process enabling to form on a same chip MOS transistors having a first gate insulator thickness and MOS transistors having a second gate insulator thickness greater than the first thickness, wherein the first (103), second (105), and third (307) transistors have the second gate insulator thickness.

11. The sensor of any of claims 1 to 10, further comprising a peripheral control circuit comprising at least one MOS transistor having a gate insulator thickness smaller than that of the first (103), second (105), and third (307) transistors.

Fig 1

Fig 2

Fig 3

Fig 4

## RÉFÉRENCES CITÉES DANS LA DESCRIPTION

**Documents brevets cités dans la description**

- US 2008296645 A
- US 2006202242 A
- EP 2966687 A